(19) Europäisches Patentamt / European Patent Office / Office européen des brevets

(11) **EP 4 764 550 A1**

(12) **EUROPEAN PATENT APPLICATION**
published in accordance with Art. 153(4) EPC

(43) Date of publication:
**24.06.2026 Bulletin 2026/26**

(21) Application number: **25848729.7**

(22) Date of filing: **04.07.2025**

(51) International Patent Classification (IPC):
*G01R 31/392* (2019.01)  *G01R 31/36* (2020.01)
*G01R 31/367* (2019.01)  *G01R 31/385* (2019.01)
*G01R 31/378* (2019.01)  *G01R 19/12* (2006.01)
*H02J 7/00* (2026.01)  *H01M 10/052* (2010.01)

(52) Cooperative Patent Classification (CPC):
**G01R 19/12; G01R 31/36; G01R 31/367;
G01R 31/378; G01R 31/385; G01R 31/392;
H01M 10/052; H02J 7/00;** Y02E 60/10

(86) International application number:
**PCT/KR2025/009581**

(87) International publication number:
**WO 2026/029404 (05.02.2026 Gazette 2026/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **01.08.2024 KR 20240102278**

(71) Applicant: **LG Energy Solution, Ltd.
Seoul 07335 (KR)**

(72) Inventor: **PARK, Heungil
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY DIAGNOSIS APPARATUS AND METHOD**

(57)    A battery diagnosis method according to an embodiment of the present invention relates to a method for diagnosing a cell abnormality during charge-/discharge testing for a module including a plurality of cells, wherein the battery diagnosis method may comprise the steps of: collecting battery-state-related measurement values for respective cycles of the charge-/discharge testing; determining whether a voltage deviation between cells within the module among the battery-state-related measurement values is greater than or equal to a set threshold value; if the voltage deviation between cells within the module is greater than or equal to the set threshold value, calculating data representing the amount of capacity changes in the module relative to the amount of changes in a charging voltage or a discharging voltage; and identifying a trend of the data representing the amount of capacity changes in the module relative to the amount of changes in the charging voltage or the discharging voltage, so as to determine an abnormal cell within the module.

[Figure 4]

## Description

[Technical Field]

This application claims priority to and the benefit of Korean Patent Application No.10-2024-0102278 filed in the Korean Intellectual Property Office on August 1, 2024 the entire contents of which are incorporated herein by reference.

The present invention relates to an apparatus and method for diagnosing batteries, and more particularly, to an apparatus and method for diagnosing lithium-sulfur batteries under performance test.

[Background Art]

Secondary batteries, capable of recharging and reuse, are manufactured as battery modules or packs by connecting multiple battery cells in series based on the output capacity required by a corresponding device, serving as power sources for diverse applications. Recently, with the development of portable electronic devices, electric vehicles, and large-capacity power storage systems, a need for large-capacity batteries is increasing.

Lithium-sulfur batteries are secondary batteries that use sulfur-based materials with sulfur-sulfur bonds as the positive electrode active material and lithium metal as the negative electrode active material. The Lithium-sulfur batteries possess higher energy density characteristics than other types of batteries. A typical lithium-sulfur battery comprises an anode made of lithium metal or a lithium metal alloy and a cathode made of elemental sulfur or other electroactive sulfur materials. When the state of charge (SOC) of a lithium-sulfur battery reaches a certain value (approximately 70%), the electrochemical reaction changes, and from that point on, the open circuit voltage (OCV) of the lithium-sulfur battery is not proportional to the state of charge (SOC).

Meanwhile, secondary batteries undergo performance testing at the final stage of the manufacturing process before shipment. However, lithium-sulfur batteries are prone to frequent fires during performance testing due to charge delay. In this case, it is difficult to predict the time of ignition and it is impossible to accurately analyze the cause after ignition, so it is difficult to take measures to prevent ignition in advance.

[Detailed Description of the Invention]

[Technical Problem]

To obviate one or more problems of the related art, embodiments of the present disclosure provide an apparatus for diagnosing batteries, particularly lithium-sulfur batteries under performance test.

To obviate one or more problems of the related art, embodiments of the present disclosure also provide a battery diagnosis method used by the battery diagnosis apparatus.

[Technical Solution]

In order to achieve the objective of the present disclosure, a battery diagnosis apparatus may include at least one processor; and a memory configured to store at least one instruction executed by the at least one processor.

Here, the at least one instruction may include an instruction to collect battery-related measurements during a discharge period included in each cycle of a battery charge/discharge test; an instruction to determine a reference value for an amount of state change in the discharge period; an instruction to compare the amount of state change in the discharge period measured for each cycle with the reference value; and an instruction to perform battery diagnosis based on a result of comparison.

The battery-related measurements may include one or more of: a discharge capacity, a discharge Open Circuit Voltage (OCV), a current, and a temperature of the battery.

The amount of state change in the discharge period may include one or more of: an amount of OCV change at the end of the rest period subsequently following the discharge period, compared to the previous cycle; and an amount of discharge capacity change during the discharge period compared to the previous cycle.

A reference value for the amount of OCV change may be calculated using a weighting factor that is set differently depending on the OCV of the previous cycle and the battery type.

A reference value for the amount of OCV change may be determined using probability density function analysis of the amount of OCV change per cycle measured during a charge/discharge test including multiple cycles.

A reference value for the amount of discharge capacity change may be calculated using a weighting factor that is set differently depending on the discharge capacity of the previous cycle and the battery type.

A reference value for the amount of discharge capacity change may be determined through probability density function analysis of the amount of discharge capacity change per cycle measured during a charge/-discharge test including multiple cycles.

The instruction to perform battery diagnosis based on the result of comparison may include an instruction to determine that a probability of occurrence of a charge delay is high during a charge period subsequently following a corresponding discharge period, if the amount of state change in the corresponding discharge period is greater than or equal to the reference value.

The at least one instruction may further include an instruction to check if there is a change in the current and temperature used in the battery charge/discharge test during a corresponding cycle; and an instruction to terminate the diagnosis if the change in the current and temperature is greater than or equal to a predetermined threshold.

According to another embodiment of the present disclosure, a battery diagnosis method may include collecting battery-related measurements during a discharge period included in each cycle of a battery charge/discharge test; determining a reference value for an amount of state change in the discharge period; comparing the amount of state change in the discharge period measured for each cycle with the reference value; and performing battery diagnosis based on a result of comparison.

The battery-related measurements may include one or more of: a discharge capacity, a discharge Open Circuit Voltage (OCV), a current, and a temperature of the battery.

The amount of state change in the discharge period may include one or more of: an amount of OCV change at the end of the rest period subsequently following the discharge period, compared to the previous cycle; and an amount of discharge capacity change during the discharge period compared to the previous cycle.

A reference value for the amount of OCV change may be calculated using a weighting factor that is set differently depending on the OCV of the previous cycle and the battery type.

A reference value for the amount of OCV change may be determined using probability density function analysis of the amount of OCV change per cycle measured during a charge/discharge test including multiple cycles.

Meanwhile, a reference value for the amount of discharge capacity change may be calculated using a weighting factor that is set differently depending on the discharge capacity of the previous cycle and the battery type.

A reference value for the amount of discharge capacity change may be determined through probability density function analysis of the amount of discharge capacity change per cycle measured during a charge/discharge test including multiple cycles.

The performing of battery diagnosis based on the result of comparison may include determining that a probability of occurrence of a charge delay is high during a charge period subsequently following a corresponding discharge period, if the amount of state change in the corresponding discharge period is greater than or equal to the reference value.

The diagnosis method may further include checking if there is a change in the current and temperature used in the battery charge/discharge test during a corresponding cycle; and terminating the battery diagnosis if the change in the current and temperature is greater than or equal to a predetermined threshold.

The battery may include a lithium-sulfur battery.

[Advantageous Effects]

According to embodiments of the present disclosure, charging delay issues in lithium-sulfur batteries can be detected in real time, allowing for proactive prevention of fire.

Furthermore, accurate cause analysis of the problem is possible by diagnosing the problem before a fire actually occurs.

[Brief Description of the Drawings]

FIG. 1 is a graph illustrating a charge delay issue that occurs during performance test of lithium-sulfur batteries.

FIG. 2 is a graph illustrating diagnostic parameters utilized in a battery diagnosis method according to embodiments of the present invention.

FIG. 3 is an operational flowchart of a battery diagnosis method according to embodiments of the present invention.

FIG. 4 is a diagram explaining a method for setting a reference value for discharge OCV change, one of the battery diagnostic parameters according to embodiments of the present invention.

FIG. 5 is a block diagram of a battery diagnosis apparatus according to embodiments of the present invention.

　　100: battery diagnosis apparatus
　　110: processor 120: memory
　　130: transceiver 140: input interface
　　150: output interface 160: storage device

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

A battery pack refers to a system of a single structure which is assembled by connecting module units set by a battery manufacturer in series/parallel and may be monitored and controlled by a battery management apparatus/system (BMS). A battery pack includes several battery modules and a battery protection unit or any other protection device.

A battery rack refers to a battery system including one or more battery packs and a battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

Hereinafter, exemplary embodiments of the present invention will be described in detail with reference to the accompanying drawings.

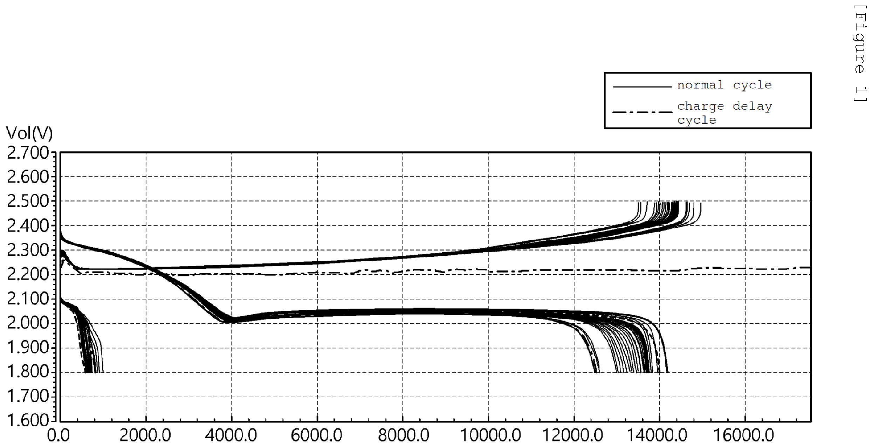

FIG. 1 is a graph explaining a charge delay issue that occurs during performance test of lithium-sulfur batteries.

Batteries are typically manufactured through electrode manufacturing, assembly, and activation/inspection processes. A completed battery, which undergoes these processes, is shipped in the form of a battery pack (or battery module) comprising a plurality of battery cells connected in series. The battery pack is connected to a load through the positive and negative terminals and may perform charge/discharge operations. Depending on the requirements of the system in which the battery is used, the battery pack may be connected in series or parallel.

Among the various battery manufacturing processes, the activation/inspection process activates electrical energy and verifies stability. The activation process involves repeated aging and charging/discharging. After the activation process, batteries undergo an inspection process to test their charge capacity and screen for defective batteries before shipment.

The battery inspection process may include a charge/discharge test to assess battery performance. This test typically involves repeated charge and/or discharge cycles.

Typically, a constant current is applied to the battery cell under test and the test is performed over several cycles in a charge-discharge test, as shown in the figure. In the graph of FIG. 1, the x-axis represents time, and the y-axis represents voltage (V). The x-axis may also represent capacity (mAh). A single charge-discharge cycle typically includes one or more "discharge" step and one or more "charge" step, with a rest period following each "discharge" and "charge" step. The graph in FIG. 1 shows two discharge steps and one charge step superimposed.

During a normal cycle, the battery cell voltage tends to decrease over time during the discharge step, which uses a negative current. During the charge step, which uses a positive current, the voltage tends to increase as the current application time increases.

However, as illustrated in the charge delay cycle in FIG. 1, cells with internal shorts or other problems exhibit a delayed voltage increase or even a complete voltage drop during the charge step, even when current is applied. When such a charge delay occurs (a charge delay cycle), the charge time increases rapidly, potentially leading to fire during performance testing.

The present invention addresses this issue by providing a diagnosis method that detects charge delays before they occur, enabling real-time pre-detection and prevention of fires caused by charge delays.

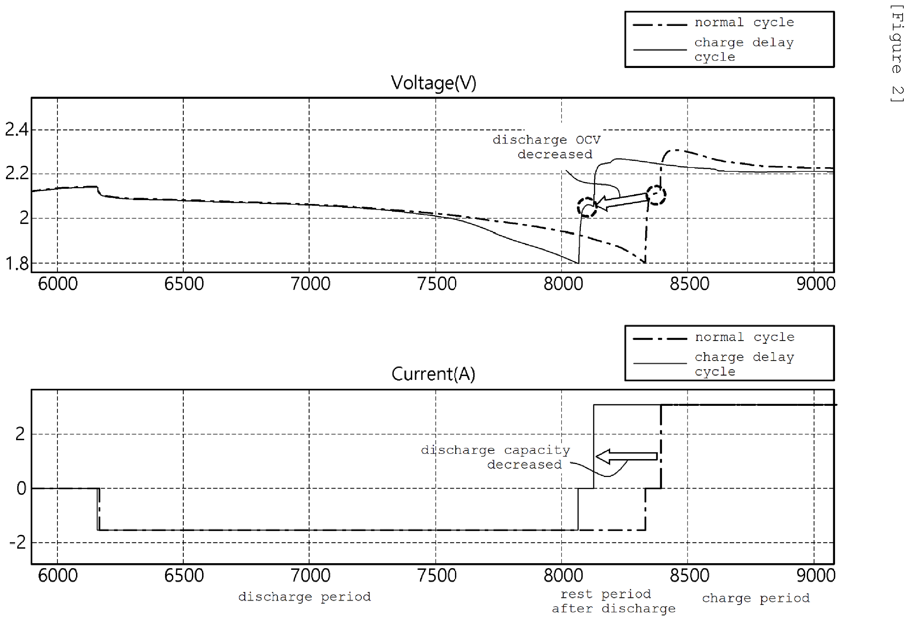

FIG. 2 is a graph for explaining diagnostic parameters utilized in a battery diagnosis method according to embodiments of the present invention.

The upper graph in FIG. 2 represents voltage values (V) over time in a normal cycle and a charge delay cycle, while the lower graph represents current values (A) over time in a normal cycle and a charge delay cycle. The graphs in FIG. 2 are constructed from voltage and current values measured in the normal cycle and the charge delay cycle obtained from experiments.

Each cycle in the upper and lower graphs of FIG. 2 includes a charge/discharge flow, consisting of a discharge period, a rest period, and a charge period, sequentially. Here, each section of the normal cycle, represented in the upper graphs (voltage), is temporally synchronized with each section of the normal cycle, represented in the lower graphs. Furthermore, each section of the charge delay cycle, represented in the lower graphs (current), is temporally synchronized with each section of the charge delay cycle, represented in the upper graphs.

Looking at the upper graphs (voltage), it is seen that the voltage (OCV) measured at the end of the rest period (0 charge current) following the discharge period in the "charge delay cycle" is lower than the voltage (OCV) measured at the end of the rest period (0 charge current) after the discharge period in the "normal cycle." In other words, if the voltage measured at the end of the rest period (0 charge current) after the discharge period in the normal cycle is a first OCV value, and the voltage measured at the end of the rest period (0 charge current) after the discharge period in the charge delay cycle is a second OCV value, it can be understood that the second OCV value is lower than the first OCV value.

Furthermore, looking at the lower graph (current), it is seen that the rest period following the discharge period begins earlier in the charge delay cycle than the normal cycle. Considering that a battery's discharge capacity is determined at the point of maximum discharge, i.e., the end of the discharge period, it can be understood that the discharge capacity of the charge delay cycle is lower than that of the normal cycle.

The present invention provides a method for diagnosing a charge delay in advance by using OCV and/or discharge capacity characteristics, as a diagnostic parameter, in the rest period after a discharge period which is located before a charge period with charge delay, wherein the discharge period is included in the cycle to which the charge period belongs.

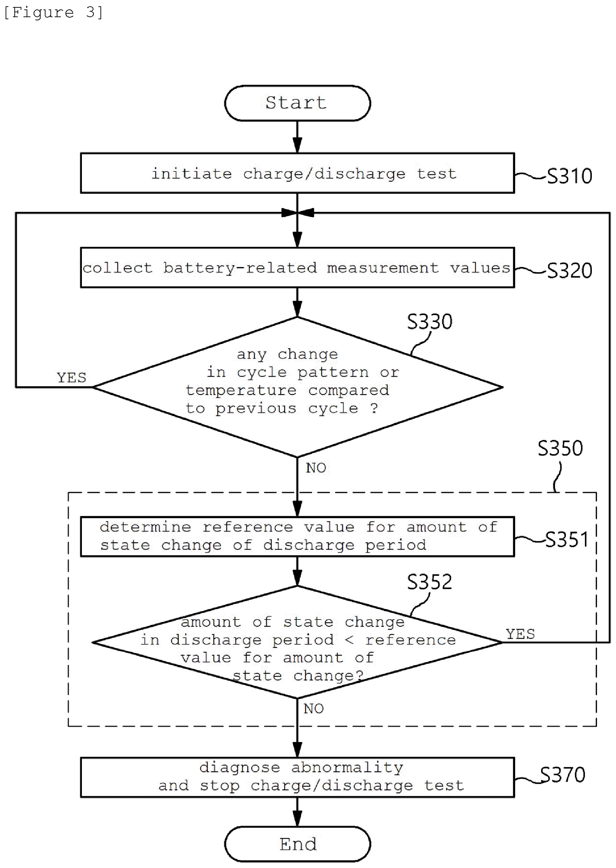

FIG. 3 is an operational flowchart of a battery diagnosis method according to embodiments of the present invention.

Battery diagnosis according to embodiments of the present invention may be performed during a charge/discharge test for performance testing. When a charge/discharge test for performance testing of a target battery (e.g., a battery cell) is initiated (S310), battery-related measurement values may be collected during a discharge period within each charge/discharge cycle (S320).

The measured values may include the pattern used in the test cycle (e.g., charge current), battery temperature, and a state value of the discharge period within each charge/discharge cycle.

More specifically, the state value of the discharge period may include one or more of the OCV and discharge capacity values at the end of the rest period following after the discharge period. Here, the discharge capacity may be calculated **at** the end of the discharge period, i.e., at the start of the rest period following after discharge. More specifically, the discharge capacity may be calculated by integrating the current from the start of the discharge period to the end of the discharge period.

Meanwhile, the OCV and discharge capacity used as diagnostic parameters in the present invention may be significantly affected by changes in cycle patterns (e.g., charge/discharge current) and temperature. Therefore, cycle patterns and temperature may act as diagnosis influencing factors in the present invention.

Reflecting this, the present invention may first monitor changes in the cycle pattern (charge current) or temperature, which are diagnosis influencing factors, before performing a diagnosis using diagnostic parameters. Specifically, it is checked if there are changes in the cycle pattern (charge current) or temperature compared to the previous cycle (S330).

If the check results show significant changes in the cycle pattern and temperature, i.e., changes exceeding a certain threshold (Yes in S330), the diagnosis using the diagnostic parameters may be stopped or the process may return to the step of collecting the the battery-related measurement data.

If there is no change in the cycle pattern and temperature compared to the previous cycle (or only a minor change), the diagnostic procedure using the diagnostic parameters (S350) may be initiated. In the diagnosis procedure (S350) according to embodiments of the present invention, a reference value for a diagnostic parameter is determined for each cycle, and the diagnostic parameter may be a reference value for an amount of state change of the discharge period. In other words, the reference value for the amount of state change in the discharge period may be set as a diagnostic parameter (S351).

Here, a state value of the discharge period may include one or more of the OCV and discharge capacity at the end of the rest period following after the discharge period. Furthermore, the amount of state change of the discharge period may include one or more of an amount of OCV change at the end of the rest period following the discharge period compared to the previous cycle and an amount of discharge capacity change of the discharge period compared to the previous cycle.

Therefore, according to an embodiment, a reference value for the amount of state change of the discharge period may include a refernce value for the amount of OCV change at the end of the rest period following the discharge period. According to another embodiment, a reference value for the amount of state change of the discharge period may include a reference value for the amount of discharge capacity change. According to yet another embodiment, the reference value for the amount of state change of the discharge period may include a reference value for the amount of OCV change at the end of the rest period following the discharge period and a reference value for the amount of discharge capacity change.

Here, the reference value for the amount of OCV change ($\triangle$OCV_th) at the end of the rest period following after the discharge period may be determined according to the following equation 1:

[Equation 1]

$$\triangle OCV_{th} = \max \ (OCV_{(n-1)} \times \beta, \ \sigma)$$

In Equation 1, $OCV_{(n-1)}$ is the OCV of the previous cycle and $\beta$ is a discharge OCV delay rate, which is a weighting factor that may be set differently depending on the type (e.g., capacity) of the lithium-sulfur battery. Additionally, $\sigma$ is a OCV-related minimum threshold, which is set for abnormality diagnosis.

Furthermore, the reference value for the amount of discharge capacity change ($\triangle$Capacity_th) during the discharge period may be determined according to Equation 2 below.

[Equation 2]

$$\triangle Capacity_{th} = Capacity_{(n-1)} \times \alpha$$

In Equation 2, $Capacity_{(n-1)}$ is the discharge capacity of the previous cycle, and $\alpha$ is a discharge capacity delay rate, a weighting factor that may be set differently depending on the type (e.g., capacity) of the lithium-sulfur battery.

Once the reference value for the amount of state change in the discharge period is set, the amount of state change in the discharge period for each cycle is compared with the reference value (S352), and the battery is diagnosed for any abnormality (S360). Specifically, if the amount of state change in the discharge period for each cycle is below the reference value (YES at S350), the corresponding cycle is determined to be a normal cycle and the next cycle is performed to collect measured values. On the contrary, if the amount of state change in the discharge period for each cycle is equal to or above the reference value (NO at S350), it is determined that there is a high probability of a charging delay in the subsequent charge period, and thus a battery abnormality is diagnosed and the charge/discharge test is terminated (S370).

In summary, a diagnostic procedure using diagnostic parameters, according to a first embodiment of the present invention, may include the steps of: setting a reference value for OCV change at the end of the rest period subsequently following the discharge period, compared to the previous cycle; and comparing an amount of OCV change measured for each cycle with the reference value for OCV change.

In addition, a diagnostic procedure using diagnostic parameters, according to a second embodiment of the present invention, may include the steps of: setting a reference value for discharge capacity change during the discharge period compared to the previous cycle; and comparing an amount of discharge capacity change measured for each cycle with the reference value for discharge capacity change.

Furthermore, a diagnostic procedure using diagnostic parameters, according to a third embodiment of the present invention, may include the steps of: setting a reference value for an amount of OCV change at the end of the rest period subsequently following the discharge period, compared to the previous cycle; setting a reference value for an amount of discharge capacity change during the discharge period compared to the previous cycle; comparing an amount of OCV change measured for each cycle with the reference value for OCV change; and comparing an amount of discharge capacity change measured for each cycle with the reference value for discharge capacity change. Here, a battery cell abnormality (e.g., an internal short circuit) may be determined when both the amount of OCV change and the amount of discharge capacity change exceed their respective reference values.

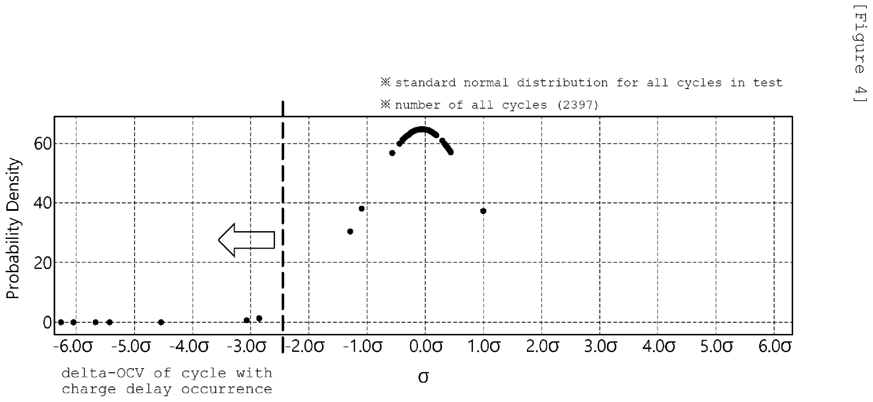

FIG. 4 is a diagram explaining a method for setting a reference value for the amount of OCV change, one of the battery diagnostic parameters according to embodiments of the present invention.

FIG. 4 shows a graph of standard normal distribution that is configured by measuring amount of OCV changes (delta-OCV) across all cycles (2,397 cycles) included in a pre-performed test and representing the probability density function of values indicating amount of OCV change.

According to results of the normal distribution analysis of the amount of OCV change, the amount of OCV change (delta-OCV) in a cycle where a charge delay occurs is observed at a position of a deviation of $-2\sigma$ (94.5%) or below from the mean of 0.0. Thus, the reference value for the amount of OCV change according to embodiments of the present invention may be determined by referencing the amount of OCV change at the $-2\sigma$ deviation.

For example, in the graph of FIG. 4, the reference value for the amount of OCV change may be derived from either the amount of OCV change at the deviation of $-2\sigma$ or any one of the amounts of OCV change located in the left side of the deviation of $-2\sigma$. Furthermore, the value for the amount of OCV change derived from the graph of FIG. 4 may be used as an initial value of the reference value for the amount of OCV change in the diagnostic procedure of FIG. 3 or used to determine the discharge OCV delay rate (β) or the OCV-related minimum **threshold** (σ) in Equation 1.

In summary, the reference value for the amount of OCV change, one of the diagnostic parameters in the present invention, may be selected through a probability density function analysis of the cycle-by-cycle OCV change amount measured during a charge/discharge test including multiple cycles.

Meanwhile, the reference value for the amount of discharge capacity change may also be determined through tests and the derivation of a probability density function distribution curve, as shown in FIG. 4, and a similar analysis process may be used to determine the reference value for discharge capacity change. In other words, the reference value for the amount of discharge capacity change, one of the diagnostic parameters in the present invention, may be selected through a probability density function analysis of the cycle-by-cycle discharge capacity change amount measured during a charge/-discharge test including multiple cycles.

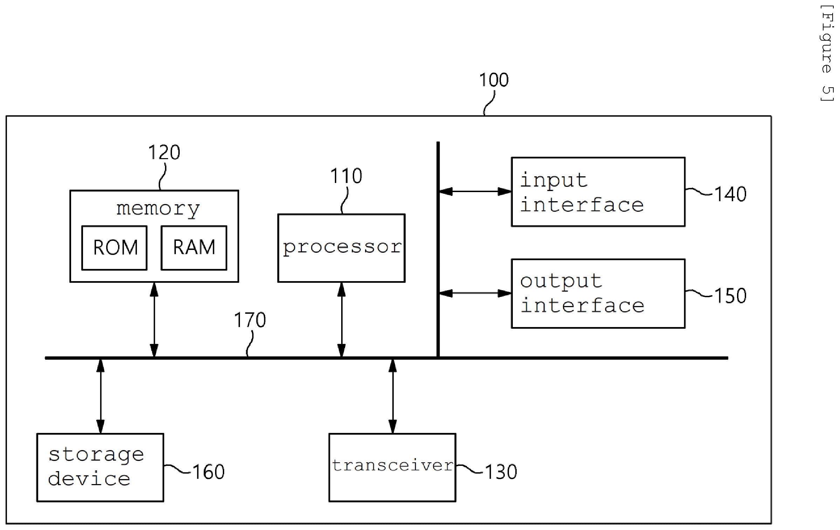

FIG. 5 is a block diagram of a battery diagnosis apparatus according to embodiments of the present invention.

Referring to FIG. 5, the battery diagnosis apparatus 100 according to embodiments of the present invention may include a processor 110 and a memory 120 that stores at least one instruction executed through the processor. Here, the processor may be, for example, a Micro Controller Unit (MCU) or another form of controller.

A battery diagnosis apparatus 100 according to embodiments of the present invention may be connected to a charger/discharger that repeatedly performs multiple charge/discharge cycles according to a charging/-discharging pattern, and may receive information about the charging/discharging pattern from the charger/-discharger. The battery diagnosis apparatus 100 may also be connected to various measuring devices (temperature sensors, voltage sensors, etc.) and receive measurement data related to battery status.

Here, the at least one instruction executed through the processor may include an instruction to collect battery-related measurements during a discharge period included in each cycle of a battery charge/-discharge test; an instruction to determine a reference value for an amount of state change in the discharge period; an instruction to compare the amount of state change in the discharge period measured for each cycle with the reference value; and an instruction to perform battery diagnosis based on a result of comparison.

The battery-related measurements may include one or more of: a discharge capacity, a discharge Open Circuit Voltage (OCV), a current, and a temperature of the battery.

The amount of state change in the discharge period may include one or more of: an amount of OCV change at the end of the rest period subsequently following the discharge period, compared to the previous cycle; and an amount of discharge capacity change during the discharge period compared to the previous cycle.

A reference value for the amount of OCV change may be calculated using a weighting factor that is set differently depending on the OCV of the previous cycle and the battery type.

A reference value for the amount of OCV change may be determined using probability density function analysis of the amount of OCV change per cycle measured during a charge/discharge test including multiple cycles.

Meanwhile, a reference value for the amount of discharge capacity change may be calculated using a weighting factor that is set differently depending on the discharge capacity of the previous cycle and the battery type.

A reference value for the amount of discharge capacity change may be determined through probability density function analysis of the amount of discharge capacity change per cycle measured during a charge/-discharge test including multiple cycles.

The instruction to perform battery diagnosis based on the result of comparison may include an instruction to determine that a probability of occurrence of a charge delay is high during a charge period subsequently following a corresponding discharge period, if the amount of state change in the corresponding discharge period is greater than or equal to the reference value.

The at least one instruction may further include an instruction to check if there is a change in the current and temperature used in the battery charge/discharge test during a corresponding cycle; and an instruction to terminate the diagnosis if the change in the current and temperature is greater than or equal to a predetermined threshold.

The battery may include a lithium-sulfur battery.

Meanwhile, the battery diagnosis apparatus 100 according to embodiments of the present invention may further include a transceiver 130, an input interface 140, an output interface 150, a storage device 160, etc. Respective components included in the battery diagnosis apparatus 100 may be connected by a bus 170 and can communicate with each other.

In addition, the memory 120 (or storage) may include at least one of a volatile storage medium and a non-volatile storage medium. For example, the memory may include at least one of read only memory (ROM) and random access memory (RAM), and may include electrically erasable programmable read-only Memory (EEPROM).

According to embodiments of the present disclosure, charging delay issues in lithium-sulfur batteries can be detected in real time, allowing for proactive prevention of fire. Furthermore, accurate cause analysis of the problem is possible by diagnosing the problem before a fire actually occurs.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

**Claims**

1. A battery diagnosis apparatus comprising:

   at least one processor; and
   a memory configured to store at least one instruction executed by the at least one processor, wherein the at least one instruction includes:

      an instruction to collect battery-related measurements during a discharge period included in each cycle of a battery charge/-discharge test;
      an instruction to determine a reference value for an amount of state change in the discharge period;
      an instruction to compare the amount of state change in the discharge period measured for each cycle with the reference value; and
      an instruction to perform battery diagnosis based on a result of comparison.

2. The apparatus of claim 1, wherein the battery-related measurements include one or more of: a discharge capacity, a discharge Open Circuit Voltage (OCV), a current, and a temperature of the battery.

3. The apparatus of claim 1, wherein the amount of state change in the discharge period includes one or more of:

      an amount of OCV change at the end of the rest period subsequently following the discharge period, compared to the previous cycle; and
      an amount of discharge capacity change during the discharge period compared to the previous cycle.

4. The apparatus of claim 3, wherein a reference value for the amount of OCV change is calculated using a weighting factor that is set differently depending on the OCV of the previous cycle and the battery type.

5. The apparatus of claim 3, wherein a reference value for the amount of OCV change is determined using probability density function analysis of the amount of OCV change per cycle measured during a charge/-discharge test including multiple cycles.

6. The apparatus of claim 3, wherein a reference value for the amount of discharge capacity change is calculated using a weighting factor that is set differently depending on the discharge capacity of the previous cycle and the battery type.

7. The apparatus of claim 3, wherein a reference value for the amount of discharge capacity change is determined through probability density function analysis of the amount of discharge capacity change per cycle measured during a charge/discharge test including multiple cycles.

8. The apparatus of claim 1, wherein the instruction to perform battery diagnosis based on the result of comparison includes:
   an instruction to determine that a probability of occurrence of a charge delay is high during a charge period subsequently following a corresponding discharge period, if the amount of state change in the corresponding discharge period is greater than or equal to the reference value.

9. The apparatus of claim 1, wherein the at least one instruction further includes:

      an instruction to check if there is a change in the current and temperature used in the battery charge/discharge test during a corresponding cycle; and
      an instruction to terminate the diagnosis if the change in the current and temperature is greater than or equal to a predetermined threshold.

10. The apparatus of claim 1, wherein the battery includes a lithium-sulfur battery.

**11.** A battery diagnosis method comprising:

collecting battery-related measurements during a discharge period included in each cycle of a battery charge/discharge test;
determining a reference value for an amount of state change in the discharge period;
comparing the amount of state change in the discharge period measured for each cycle with the reference value; and
performing battery diagnosis based on a result of comparison.

**12.** The method of claim 11, wherein the battery-related measurements include one or more of: a discharge capacity, a discharge Open Circuit Voltage (OCV), a current, and a temperature of the battery.

**13.** The method of claim 11, wherein the amount of state change in the discharge period includes one or more of:

an amount of OCV change at the end of a rest period subsequently following the discharge period, compared to a previous cycle; and
an amount of discharge capacity change during the discharge period compared to the previous cycle.

**14.** The method of claim 13, wherein a reference value for the amount of OCV change is calculated using a weighting factor that is set differently depending on the OCV of the previous cycle and the battery type.

**15.** The method of claim 13, wherein a reference value for the amount of OCV change is determined using probability density function analysis of the amount of OCV change per cycle measured during a charge/-discharge test including multiple cycles.

**16.** The method of claim 13, wherein a reference value for the amount of discharge capacity change is calculated using a weighting factor that is set differently depending on the discharge capacity of the previous cycle and the battery type.

**17.** The method of claim 13, wherein a reference value for the amount of discharge capacity change is determined through probability density function analysis of the amount of discharge capacity change per cycle measured during a charge/discharge test including multiple cycles.

**18.** The method of claim 11, wherein the performing of battery diagnosis based on the result of comparison includes:
determining that a probability of occurrence of a charge delay is high during a charge period subsequently following a corresponding discharge period, if the amount of state change in the corresponding discharge period is greater than or equal to the reference value.

**19.** The method of claim 11, further comprising:

checking if there is a change in the current and temperature used in the battery charge/-discharge test during a corresponding cycle; and
terminating the diagnosis if the change in the current and temperature is greater than or equal to a predetermined threshold.

**20.** The method of claim 11, wherein the battery includes a lithium-sulfur battery.

[Figure 1]

[Figure 2]

[Figure 3]

```
                          ┌──────────┐
                          │  Start   │
                          └──────────┘
                               │
                               ▼
        ┌──────────────────────────────────────────┐
        │       initiate charge/discharge test      │──S310
        └──────────────────────────────────────────┘
                               │
                               ▼
        ┌──────────────────────────────────────────┐
        │   collect battery-related measurement values │──S320
        └──────────────────────────────────────────┘
                               │
                               ▼              S330
                        ╱──────────────╲
              YES      ╱   any change    ╲
         ◄────────────    in cycle pattern or
                        ╲ temperature compared ╱
                         ╲ to previous cycle ? ╱
                          ╲────────────────╱
                               │ NO
                               ▼                    S350
        ┌─ ─ ─ ─ ─ ─ ─ ─ ─ ─ ─ ─ ─ ─ ─ ─ ─ ─ ─ ─ ─ ─ ┐
        │  ┌────────────────────────────────────────┐ │
        │  │ determine reference value for amount of │──S351
        │  │  state change of discharge period       │ │
        │  └────────────────────────────────────────┘ │
        │                    │                         │
        │                    ▼            S352          │
        │             ╱──────────────╲                 │
        │            ╱ amount of state ╲      YES       │
        │            ╲ change in discharge period < reference ├──►
        │             ╲ value for amount of            │
        │              ╲ state change? ╱               │
        │               ╲────────────╱                 │
        │                    │ NO                       │
        └─ ─ ─ ─ ─ ─ ─ ─ ─ ─ ─ ─ ─ ─ ─ ─ ─ ─ ─ ─ ─ ─ ─ ┘
                               │
                               ▼
        ┌──────────────────────────────────────────┐
        │          diagnose abnormality             │──S370
        │      and stop charge/discharge test       │
        └──────────────────────────────────────────┘
                               │
                               ▼
                          ┌──────────┐
                          │   End    │
                          └──────────┘
```

[Figure 4]

[Figure 5]

**TRANSLATION**

### INTERNATIONAL SEARCH REPORT

| International application No. |
|---|
| **PCT/KR2025/009581** |

| A. | CLASSIFICATION OF SUBJECT MATTER |
|---|---|

**G01R 31/392**(2019.01)i; **G01R 31/36**(2006.01)i; **G01R 31/367**(2019.01)i; **G01R 31/385**(2019.01)i; **G01R 31/378**(2019.01)i; **G01R 19/12**(2006.01)i; **H02J 7/00**(2006.01)i; **H01M 10/052**(2010.01)i

According to International Patent Classification (IPC) or to both national classification and IPC

| B. | FIELDS SEARCHED |
|---|---|

Minimum documentation searched (classification system followed by classification symbols)

G01R 31/392(2019.01); B60L 3/00(2006.01); B60L 58/12(2019.01); G01R 31/36(2006.01); G01R 31/367(2019.01); G01R 31/374(2019.01); G01R 31/382(2019.01); G01R 31/387(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 배터리 충방전 테스트(battery charge/discharge test), 사이클(cycle), 방전 구간 (discharge interval), 변화량(amount of change), 진단(diagnosis)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2024-0082760 A (LG ENERGY SOLUTION, LTD.) 11 June 2024 (2024-06-11)<br>paragraphs [0065]-[0118] and figures 6-7 | 1-20 |
| A | KR 10-2024-0041099 A (ORANGE.I CO., LTD.) 29 March 2024 (2024-03-29)<br>paragraphs [0036]-[0091], claim 1 and figures 1-10 | 1-20 |
| A | CN 112946496 A (NINGDE CONTEMPORARY AMPEREX TECHNOLOGY CO., LTD.) 11 June 2021 (2021-06-11)<br>paragraphs [0032]-[0066] and figures 1-4 | 1-20 |
| A | KR 10-2022-0129944 A (RESEARCH & BUSINESS FOUNDATION SUNGKYUNKWAN UNIVERSITY) 26 September 2022 (2022-09-26)<br>paragraphs [0019]-[0100] and figure 2 | 1-20 |
| A | KR 10-2023-0088644 A (QUANTUM SOLUTION) 20 June 2023 (2023-06-20)<br>paragraphs [0094]-[0095] and figure 6 | 1-20 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 October 2025** | **16 October 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2025/009581**

| Patent document cited in search report | | | Publication date (day/month/year) | Patent family member(s) | | | Publication date (day/month/year) |
|---|---|---|---|---|---|---|---|
| KR | 10-2024-0082760 | A | 11 June 2024 | None | | | |
| KR | 10-2024-0041099 | A | 29 March 2024 | None | | | |
| CN | 112946496 | A | 11 June 2021 | CN | 110988720 | A | 10 April 2020 |
| | | | | CN | 110988720 | B | 09 March 2021 |
| | | | | CN | 112946496 | B | 12 July 2024 |
| | | | | EP | 3783377 | A1 | 24 February 2021 |
| | | | | EP | 3783377 | A4 | 21 July 2021 |
| | | | | EP | 3783377 | B1 | 11 September 2024 |
| | | | | EP | 3783377 | B8 | 23 October 2024 |
| | | | | HU | E069367 | T2 | 28 March 2025 |
| | | | | JP | 2022-526572 | A | 25 May 2022 |
| | | | | JP | 7194887 | B2 | 23 December 2022 |
| | | | | KR | 10-2021-0150463 | A | 10 December 2021 |
| | | | | KR | 10-2606496 | B1 | 29 November 2023 |
| | | | | US | 11899071 | B2 | 13 February 2024 |
| | | | | US | 2023-0095453 | A1 | 30 March 2023 |
| | | | | WO | 2020-259355 | A1 | 30 December 2020 |
| KR | 10-2022-0129944 | A | 26 September 2022 | KR | 10-2634373 | B1 | 06 February 2024 |
| KR | 10-2023-0088644 | A | 20 June 2023 | KR | 10-2022-0064547 | A | 19 May 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240102278